# EUROPÄISCHE PATENTSCHRIFT

(11) **EP 0 841 728 B1**
(45) Veröffentlichungstag und Bekanntmachung des Hinweises auf die Patenterteilung: **08.08.2001**
(21) Anmeldenummer: 97119037.6
(22) Anmeldetag: 31.10.1997
(51) Int. Cl.: H01R 33/02, H01R 33/08, H01R 13/514

(54) **Fassung für elektrische und elektronische Komponenten**
Socket for electrical and electronical components
Douille pour composants électriques et électroniques

(30) Priorität: 12.11.1996 DE 19646523
(43) Veröffentlichungstag der Anmeldung: 13.05.1998
(73) Patentinhaber: MOLEX INCORPORATED, Lisle Illinois 60532 (US)
(72) Erfinder: Busse, Frank, 76275 Ettlingen (DE); Reifel, Dirk, 76297 Stutensee (DE); Schwarz, Uwe, 76275 Ettlingen (DE)
(74) Vertreter: Blumbach, Kramer & Partner GbR

(56) Entgegenhaltungen:
- EP-A- 0 634 889
- DE-A- 2 234 726
- DE-A- 2 310 151
- DE-A- 2 421 056
- DE-A- 3 146 515
- DE-A- 19 520 416
- DE-U- 7 614 462
- US-A- 4 799 896
- US-A- 5 118 308

## Beschreibung

Die Erfindung betrifft eine Fassung für elektrische und elektronische Bauelemente mit Ausnahme von Leuchtmitteln gemäß Anspruch 1, eine Anordnung aus mehreren derartigen Fassungen nach Anspruch 17 sowie ein Verfahren zum Fixieren und Kontaktieren einer elektrischen oder elektronischen Komponente innerhalb einer solchen Fassung nach Anspruch 18.

Elektrische Bauteile werden bekannterweise auf einer Leiterplatte montiert, indem sie an definierten Stellen auf die Oberfläche der Leiterplatte geklebt oder mit ihren Anschlußstiften in kontaktierte Löcher eingesetzt und mit diesen verlötet werden. Auf diese Weise montierte elektrische Bauelemente, insbesondere Fotodioden oder Fototransitoren lassen sich jedoch nicht mehr in ihrer Lage korrigieren.

Aus der US-A-5,118,308 ist ein mehrteiliger Busverbinder mit einem Basisteil bekannt, in dem mehrere Schlitze vorgesehen sind, durch die gabelförmige Anschlußkontakte hindurchgesteckt werden können. Die Anschlußkontakte ragen im eingesetzten Zustand mit ihren gabelförmigen Abschnitten aus den Schlitzen hervor. Ein oberes Gehäuseteil weist unter anderem mehrere Widerstandskammern, in die Widerstände, die einen Bus abschließen, eingesetzt werden können. Das obere Gehäuseteil weist ferner mehrere Rillen zur Aufnahme von Anschlussdrähten der Widerstände auf. Sind das Basisteil und das obere Gehäuseteil zusammengefügt, greifen die Anschlussdrähte der Widerstände in die gabelförmigen Abschnitte der Anschlußkontakte ein und werden dadurch in den Rillen gehalten.

Aus der DE-OS 2421056 ist eine Komponenten-Verbindungsklemmeinrichtung bekannt, mit der eine elektrische Komponente, wie z.B. ein Widerstand, zwischen die Leiter eines Stromkreises geschaltet wird. Die Komponenten-Verbindungsklemmeinrichtung weist einen ersten und zweiten Teil mit geeigneten Kontaktoberflächen und Eingriffselementen auf, die im zusammengefügten Zustand die Oberflächen der Teile in Kontaktstellung halten. Die Oberfläche des ersten und zweiten Teils weist jeweils neben zwei Kanälen zur Aufnahme jeweils eines Leiters auch einen Hohlraum auf, der eine elektrische Komponente mit sich axial erstreckenden Kontaktdrähten aufnehmen kann. In dem zweiten Teil sind zwei im Abstand zueinander angeordnete Kontaktelemente derart angeordnet, daß die in dem Hohlraum eingesetzte Komponente quer über den in den Kanälen angeordnete Leiter bei zusammengefügter Verbindungsklemmeinrichtung geschaltet wird.

Aus der EP-A-0 634 889 ist ein Zuführungs- und Haltebauteil für elektrische Komponenten, wie z.B. Mikrolampen, bekannt. Das Bauteil umfasst ein Gehäuse, in welches eine solche Mikrolampe eingesetzt werden kann. Der Bodenteil des Gehäuses bildet einen Schlitz, durch den die Anschlußdrähte der Mikrolampe aus dem Gehäuse herausgeführt werden. Außerhalb des Gehäuses sind Koppelungssitze zur Aufnahme elektrischer Widerstände vorgesehen, die einen entsprechenden Verbindungsleiter sowie einen der Anschlußdrähte der Mikrolampe kontaktieren.

Die DE OS 2310151 offenbart eine Fassung für sockellose elektrische Kleinlampen, die ein Gehäuse mit einem Einsteckraum für den Glaskolben einer elektrischen Kleinlampe aufweist. Gehäuseschlitze, die quer zur Einsetzrichtung des Glaskolbens verlaufen, erstrecken sich in den Einsteckraum. Kontaktfahnen ragen mit einem Ende aus dem Gehäuse heraus und mit dem anderen Ende durch die Gehäuseschlitze in den Einsteckraum hinein. Aus dem Glaskolben ragen Leitungsdrähte heraus, die beim Einsetzen des Glaskolbens in den Einsteckraum in Einsetzrichtung des Glaskolbens gebogen werden. Im eingesetzten Zustand kommen die Enden der Kontaktfahnen im Einsteckraum in Kontakt mit den Leitungsdrähten des Glaskolbens.

Aus der DE-U-7614462 ist eine Steckfassung zur Aufnahme der Anschlüsse separater Bauelemente bekannt. Dazu weist die Steckfassung mehrere Buchsenkontakte auf, welche jeweils mit einer hohlen Kappe abgedeckt sind. Beim Einsetzen eines Bauelementes kommen dann dessen Stiftkontakte innerhalb jeder Kappe in Kontakt mit den Buchsenkontakten.

Der Erfindung liegt nunmehr die Aufgabe zugrunde, einen Sockel, besser gesagt eine Fassung für elektrische und elektronische Bauelemente verfügbar zu machen, die kostengünstig herstellbar ist, ohne großen Aufwand auch vom Kunden selbst an Ort und Stelle montiert werden kann, **wobei ein eingesetztes Bauelemente** in Bezug auf die Fassung positionierbar ist.

Dieses technische Problem löst die Erfindung mit den Merkmalen des Anspruchs 1.

Die erfindungsgemäße Fassung dient insbesondere der mechanischen Stabilisierung, einer definierten Positionierung eines elektrischen oder elektronischen Bauteils sowie der zuverlässigen elektrischen Verbindung. Bei dem Bauteil handelt es sich beispielsweise um einen elektrischen Widerstand, eine Spule einen Kondensator, einen Transistor, eine Diode u.s.w.

Hierzu weist die **einstückig ausgebildete** Fassung eine oder mehrere Kappen zur Aufnahme wenigstens eines vorbestimmten, wenigstens einen Anschlußkontakt aufweisenden Teils einer elektrischen oder elektronischen Komponente auf, wobei die Kappe derart bemessen ist, daß fertigungsbedingte Toleranzen der Komponente ausgeglichen werden können. Jeder Kappe ist wenigstens eine Kammer zur Aufnahme eines Kontaktelementes zugeordnet, wobei das Kontaktelement derart ausgebildet ist, daß es im eingesetzten Zustand mit dem Anschlußkontakt innerhalb der Kammer eine elektrisch leitende Preßverbindung bildet.

Weitere vorteilhafte Weiterbildungen sind in den Unteransprüchen umschrieben.

Von der Kappe führt ein erstes Loch in die Kammer, durch das der Anschlußkontakt, das ist vorteilhafterweise ein Elektrodendraht, beim Einführen der Komponente hindurchgesteckt wird. Um das Einfädeln des Anschlußkontaktes der Komponente, zu erleichtern, verjüngt sich die Querschnittsfläche der Kappe in Einsetzrichtung der Komponente. Die Kontakt-Aufnahmekammer verläuft in Bezug auf die Einsetzrichtung der Komponente zweckmäßigerweise rechtwinklig und ist hinter der Kappe angeordnet. Die Kammer kann als Durchgang ausgebildet sein, oder verläuft nur teilweise durch die Fassung.

Um den Anschlußdraht der Komponente beim Kontaktieren und Handhaben gegen Belastungen, die bei den bekannten Fassungen auftreten, zu schützen, weist die die Kammer begrenzende Rückseite der Fassung ein zum ersten Loch fluchtendes zweites Loch auf, wobei der Abstand zwischen den Löchern derart bemessen ist, daß die während des Aufpressens des Kontaktelements auftretenden Kräfte im wesentlichen von der Fassung aufgenommen und nicht in die Komponente geleitet werden. Auf diese Weise entsteht eine formschlüssige Verbindung, welche sicherstellt, daß der Elektrodendraht und damit die Komponente auch bei mechanischen Erschütterungen, die beispielsweise während eines Einsatzes in Kraftfahrzeugen auftreten, sicher gehalten wird. Das zweite Loch wirkt auch als Amboß, wenn der aus der Fassung herausragende Abschnitt des Anschlußdrahtes abgeschnitten wird.

Zusammen mit der zwischen dem Kontaktelement und dem Anschlußdraht bestehenden Preßverbindung gewährleistet der erfindungsgemäße Fassung für viele Anwendungen eine hohe mechanische Stabilität und sichere elektrische Verbindung zur montierten elektrischen oder elektronischen Komponente.

Um das Kontaktelement beim Einsetzen gegen ein Verkanten zu schützen und eine Friktion zwischen dem Kontaktelement und der Kammer im wesentlichen zu vermeiden, weist diese Führungsrillen und/oder Führungsnuten auf, die wenigstens teilweise in der Kammer verlaufen. Das Kontaktelement selbst weist Vorsprünge auf, die wenigstens im eingesetzten Zustand mit den jeweiligen Führungsnuten zusammenwirken. Bei den Vorsprüngen kann es sich um Ausprägungen handeln, die durch entsprechende Einprägungen auf der gegenüberliegenden Seite des Kontaktelements hervorgerufen werden.

Bei dem Kontaktelement handelt es sich vorzugsweise um einen Kontaktstift, der an einem Ende in zwei Kontaktschenkeln ausläuft, die im eingesetzten Zustand mit dem Anschlußkontakt der Komponente eine Preßverbindung bilden.

Das Kontaktelement weist Rastvorsprünge auf, die im eingesetzten Zustand mit der Kammer derart zusammenwirken, daß das Kontaktelement fest in der Kammer gehalten und gegen ein unerwünschtes Herausziehen geschützt ist. Das Kontaktelement kann auch als Schneid-Klemm-Kontakt ausgebildet sein.

Sobald das Kontaktelement mit dem Anschlußkontakt eine Preßverbindung bildet und die Position der Komponente in Bezug auf den Fassung bzw. das Kontaktelement festgelegt ist, wird ein Füllmaterial, insbesondere eine dauerelastische Klebevergußmasse, durch eine Öffnung in die Kappe eingefüllt. Bei der Klebevergußmasse kann es sich um einen Hochtemperatur-Schmelzkleber oder um ein mittels UV-Bestrahlung aushärtbares Kunstharz handeln, dessen elastische Eigenschaft zweckmäßigerweise so gewählt wird, daß Vibrationen und andere externe Belastungen gegenüber der Komponente gedämpft werden. Damit ist ein ausreichender Schutz der Komponente gegenüber Erschütterungen und Vibrationen möglich.

An der Fassung können Halte-, Führungs- und/oder Rasteinrichtungen zum lösbaren Verbinden mit wenigstens einem weiteren Fassung vorgesehen sein. Dabei können die Fassungen nebeneinander oder auch teilweise sternförmige miteinander verbunden werden. Als Verbindungseinrichtungen bieten sich u. a. schwalbenschwanzförmige Keile und komplementär dazu geformte Aufnahmen an. Die Halte-, Führungs- und/oder Rasteinrichtungen sind derart dimensioniert, daß die Fassungen ausreichend Spiel zueinander aufweisen, um durch herstellungsbedingte Toleranzen verursachte Spannungen innerhalb einer Anordnung ausgleichen zu können.

Die Fassung kann auch mehrere, in definierter Lage zueinander angeordnete Kappen aufweisen, denen jeweils eine Kammer zum Einsetzen eines Kontaktelements zugeordnet ist. In diesem Fall ist es möglich, beispielsweise Fotodioden mit unterschiedlicher, wellenlängenabhängiger Empfindlichkeit in einem Fassung zu montieren, die je nach Bedarf getrennt voneinander ansteuerbar sind.

Sind bezüglich der Einsteckrichtung der Komponente hinter der Kappe mehrere Kammern hintereinander angeordnet und mittels durchgehender Löcher miteinander verbunden, so kann eine montierte Komponente mit unterschiedlichen Spannungen getrennt angesteuert werden.

Um die Montage einer mit einer Fassung versehenen elektrischen oder elektronischen Komponente beispielsweise auf einer Leiterplatte zu erleichtern, weist die Fassung entsprechende Positionierstifte oder -löcher und/oder eine Führungsnut auf. An dieser Stelle sei darauf hingewiesen, daß die besondere Gestaltung der Fassung und des Kontaktelements einen automatisierten Montageprozeß erlauben. Allerdings können auch, wie bereits erwähnt, fachunkundige Personen selbst an Ort und Stelle die Fassung mit einer elektrischen oder elektronischen Komponente verbinden und kontaktieren und anschließend diese Baugruppe an einer Leiterplatte montieren.

Die bisher beschriebene Fassung ist für Komponenten mit einem Durchmesser von beispielsweise 6 mm geeignet. Um elektroniche Bauteile mit kleinerem Durchmesser, beispielsweise 3 mm, aufnehmen zu können, sind an der Innenfläche der Kappe in Bezug zur Einsetzrichtung des elektronischen Bauteils mehrere parallel verlaufende Rippen angeordnet, die den Querschnitt der Kappe entsprechend verkleinern. Die Rippen sind beispielsweise an der Innenfläche der Kappe angeformt. Eine alternative Ausbildungsform sieht einen getrennten Einsatz mit Rippen vor, der in die Kappe einsetzbar und mit dieser verrastbar ist. Dies hat den Vorteil, daß die Kappen eine Einheitsgröße aufweisen können.

In vorteilhafter Weise ist die Fassung einstückig aus einem dielektrischen Spritzgußmaterial hergestellt. Es können auch andere dielektrische Materialien, wie z. B. Duroplaste, verwendet werden.

Um die Fassung an einer Trägereinrichtung befestigen zu können, weist die Fassung Aussparungen auf, in die Rastarme der Trägereinrichtung eingreifen können. Alternativ oder zusätzlich können an der Fassung Rastarme vorgesehen sein, die in entsprechende Aussparungen der Trägereinrichtung eingreifen.

Eine Anordnung aus mehreren erfindungsgemäßen Fassungen ist in Anspruch 17 und ein Verfahren zum Fixieren und Kontaktieren wenigstens eines Bauteils in Anspruch 18 umschrieben.

Die Erfindung wird nachstehend anhand einer Ausführungsform beispielhaft in Verbindung mit den beiliegenden Zeichnungen näher erläutert. Für gleiche Merkmale werden gleiche Bezugszeichen verwendet. Es zeigen:
- Fig. 1: eine perspektivische Ansicht einer an einem Ende einer Fotodiode montierten erfindungsgemäßen Fassung,
- Fig. 2: einen Längsschnitt der Fassung nach Fig. 1 entlang der Linie A-A,
- Fig. 3: einen Querschnitt der Fassung nach Fig. 1 entlang der Linie B-B mit einem teilweise eingesetzten Kontaktstift,
- Fig. 4: eine Vorderansicht einer Fassung mit zwei Kappen
- Fig. 5: die Vorderansicht einer alternativen Fassung mit einer einzigen Kappe und zwei zugeordneten Kontaktelementen.
- Fig. 6: die Draufsicht einer lösbaren Anordnung von vier Fassungen in Sternform,
- Fig. 7: die Vorderansicht einer alternativen Fassung mit einer Kappe, deren Aufnahmebereich mittels Rippen verkleinert worden ist.

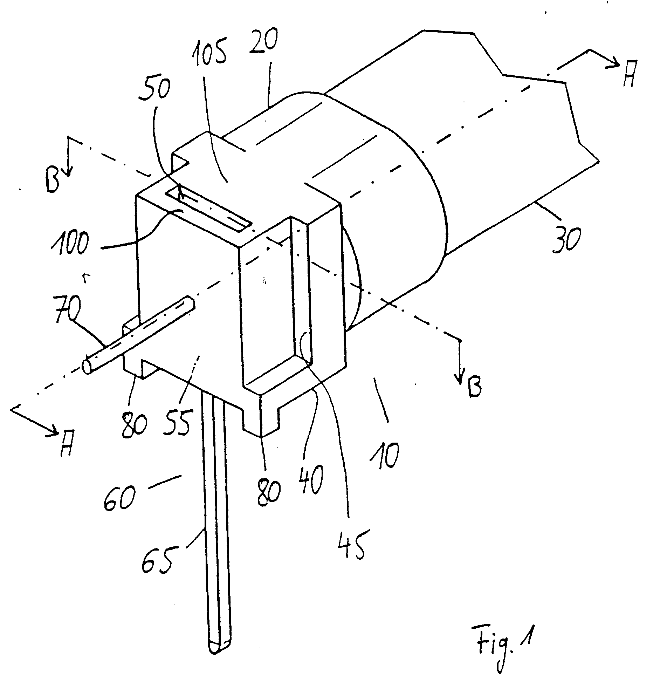

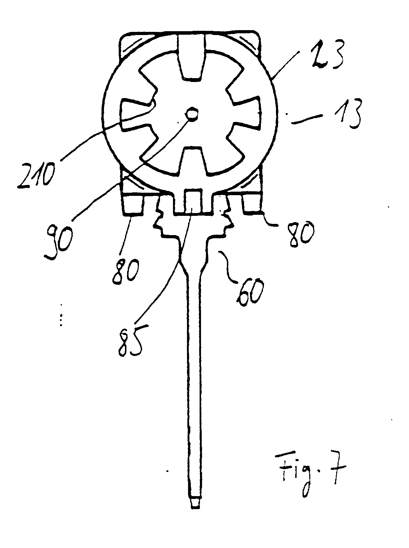

In Fig. 1 ist eine perspektivische Darstellung einer mit 10 bezeichneten Fassung dargestellt. Die Fassung 10 weist eine Kappe 20 auf, die den Aufnahmebereich beispielsweise für das eine Ende eines elektrischen Bauelements, wie z. B. einer Fotodiode, bildet. Ein Endabschnitt dieser Fotodiode 30 ist in Fig. 1 dargestellt. Die Fassung 10 weist ferner einen an die Kappe 20 anschließenden hinteren Teil 40 auf, in dem eine Kammer 50 zur Aufnahme eines Kontaktstiftes 60 angeordnet ist. Obwohl in diesem Beispiel als Kammer ein Durchgang 50 beschrieben wird, ist es natürlich denkbar, eine nur teilweise sich durch den hinteren Teil 40 erstreckende Kammer vorzusehen. Der Durchgang 50 verläuft rechtwinklig zur Einsetzrichtung der Fotodiode 30. Die Fotodiode 30 weist an jedem Ende einen Elektroden- oder Anschlußdraht 70 auf, der im montierten Zustand mit dem Kontaktstift 60 eine elektrisch leitende Preßverbindung bildet. Wie in Fig.1 zu sehen ist, sind an der Fassung 10 Zentrierstifte 80 angeformt, die das Montieren der Fassung 10 beispielsweise auf einer Leiterplatte erleichtern helfen. Zu diesem Zweck kann an der Fassung ferner eine Führungsnut 85, wie z. B. in Fig. 7 angedeutet, vorgesehen sein. Die Führungsnut 85 dient auch der Montagehilfe. Der Kontaktstift 60 wird in dieser Ausführungsform von unten in den Durchgang 50 eingesetzt, d. h. von der Seite, an der die Zentrierstifte 80 an der Fassung 10 angeformt sind. Diese sogenannte Einsetzöffnung ist mit 55 bezeichnet. In dem hinteren Teil 40 sind seitlich Aussparungen 45 ausgenommen, in die Rastarme einer Trägereinrichtung eingreifen können. Alternativ oder zusätzlich können an der Fassung 10 Rastarme ausgebildet sein, die in entsprechende Aussparungen an der Tägereinrichtung eingreifen.

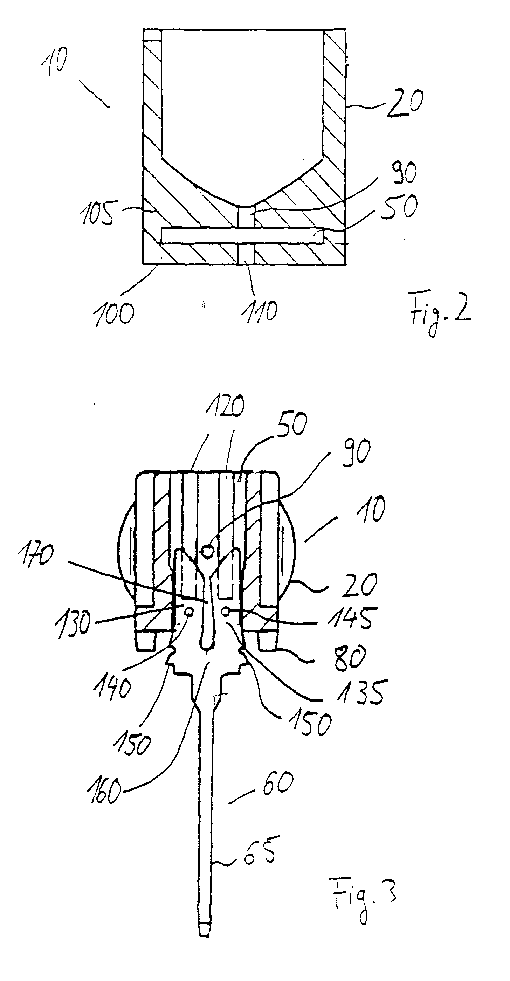

Fig. 2 zeigt einen Längsschnitt entlang der Linie A-A durch die Fassung 10 nach Fig. 1. Danach weist die Kappe 20 eine sich in Einsetzrichtung der Fotodiode 30, d. h. in Richtung zum hinteren Fassungteil 40, verjüngende Querschnittsfläche auf. Die Querschnittsfläche entspricht etwa der eines Trichters. Der trichterförmige Aufnahmeraum der Kappe 20 mündet in ein Loch 90, das wiederum in den Durchgang 50 führt. Der trichterförmig sich verjüngende Aufnahmeraum der Kappe 20 erleichtert das Einfädeln des Anschlußdrahtes 70 beim Aufschieben der Fassung 10 auf das eine Ende der Fotodiode 30. In der rückwärtigen Wand 100, die den Durchgang 50 begrenzt, ist ebenfalls ein Loch 110 vorgesehen, das mit dem Loch 90 in der Kappe 20 fluchtet. Die zueinander fluchtenden Löcher oder Öffnungen 90, 110 dienen dazu, den Anschlußdraht 70 der Fotodiode 30 auszurichten und zu stützen. Der Abstand zwischen beiden Öffnungen 90, 110 ist derart zu wählen, daß die während des Einsetzens des Kontaktstiftes 60 auftretenden Kräfte im wesentlichen nicht über den Anschlußdraht 70 in die Fotodiode 30 geleitet werden. Auf diese Weise ist gewährleistet, daß beim Kontaktieren der Fotodiode 30 keine Beschädigung an den Kontaktstellen und an der Fotodiode selbst auftritt.

In Fig. 3 ist ein Querschnitt entlang der Linie B-B durch die in Fig. 1 dargestellten Fassung 20 gezeigt. Im wesentlichen zeigt Fig. 3 den Durchgang 50 der Fassung 10 und den teilweise eingesetzten Kontaktstift 60. Der Durchgang 50 weist wenigstens an einer Begrenzungswand, das ist die rückwärtige Wand 100 oder die Wand 105, die den Durchgang 50 mit der Kappe 20 verbindet, zwei Führungsnuten 120 auf, die parallel zur Einsetzrichtung des Kontaktstiftes 60 verlaufen. Die Führungsnuten 120 erstrecken sich vorzugsweise nicht vollständig durch den Durchgang 50, sondern enden in einem gewissen Abstand vor der Einsetzöffnung 55 des Durchgangs 50. Die Querschnittsfläche des Durchgangs 50 ist derart bemessen, daß sie im Bereich der Einsetzöffnung 55 geringfügig breiter ist als der Kontaktstift 60 selbst und dann in Einsetzrichtung des Kontaktstiftes 60 breiter wird, damit der Kontaktstift 60 über den Anschlußdraht 70 gepreßt werden kann. Darüber hinaus ist in Fig. 3 ausführlich die Form des beispielhaften Kontaktstiftes 60 dargestellt. Der Kontaktstift 60 weist einen länglichen Stift 65 auf, der beispielsweise zum Kontaktieren der Fassung 10 mit einer Leiterplatte dient. Der Stift 65 erstreckt sich zu einem Basisbereich 160, der senkrecht zum länglichen Stift 65 verläuft. Vom Basisbereich 160 aus erstrecken sich zwei Kontaktschenkel 130 und 135 parallel zur Einsetzrichtung. An ihrem äußeren Ende sind die Kontaktschenkel 130 und 135 abgeschrägt und bilden eine V-förmige Öffnung. Die V-förmige Öffnung mündet in einen von den beiden Schenkeln 130, 135 gebildeten Kanal 170, dessen Eingangsmündung schmaler ist als der Durchmesser des Anschlußdrahtes 70. In Richtung zum länglichen Stift 65 weitet sich der Kanal 170 tropfenförmig bis zu einer Größe aus, die etwa dem Durchmesser des Anschlußdrahtes 70 entspricht. Jeder Kontaktschenkel 130, 135 weist einen Wulst 140 bzw. 145 auf, der beim Einsetzen des Kontaktstiftes 60 in den Durchgang 50 mit der jeweiligen Führungsnut 120 zusammenwirkt, um den Kontaktstift 60 gegen ein Verkanten zu schützen und dafür zu sorgen, daß sich die Kontaktschenkel 130 und 135 frei bewegen können, so daß der Kontaktdruck nur unwesentlich durch Friktion zwischen dem Kontaktstift 60 und dem Durchgang 50 beeinflußt wird. Am Basisteil 160 des Kontaktstiftes 60 sind Vorsprünge 150 in Form von Rasthaken ausgebildet, die beim Einsetzen des Kontaktstiftes 60 in die Wandungen des Durchgangs 50 eindringen. Der eingesetzte Kontaktstift 60 wird auf diese Weise in dem Durchgang gehalten und gegen ein unerwünschtes Herausziehen geschützt. Im eingesetzten Zustand bildet der in Fig. 3 dargestellte Kontaktstift 60 eine Preßverbindung mit dem Anschlußkontakt 70 der Fotodiode 30. Fig. 3 zeigt ferner das Loch 90 in der Kappe 20, durch das der Anschlußdraht 70 beim Aufbringen der Fassung 10 auf die Fotodiode 30 hindurchgeschoben wird. Es ist selbstverständlich, daß neben dem hier dargestellten Kontaktstift 60 beliebig geformte Kontaktstifte zum Einsatz kommen können, die eine Preßverbindung mit dem Anschlußdraht 70 herstellen können. Beispielsweise sei hier an einen Kontaktstift in Schneid-Klemm-Technik erinnert.

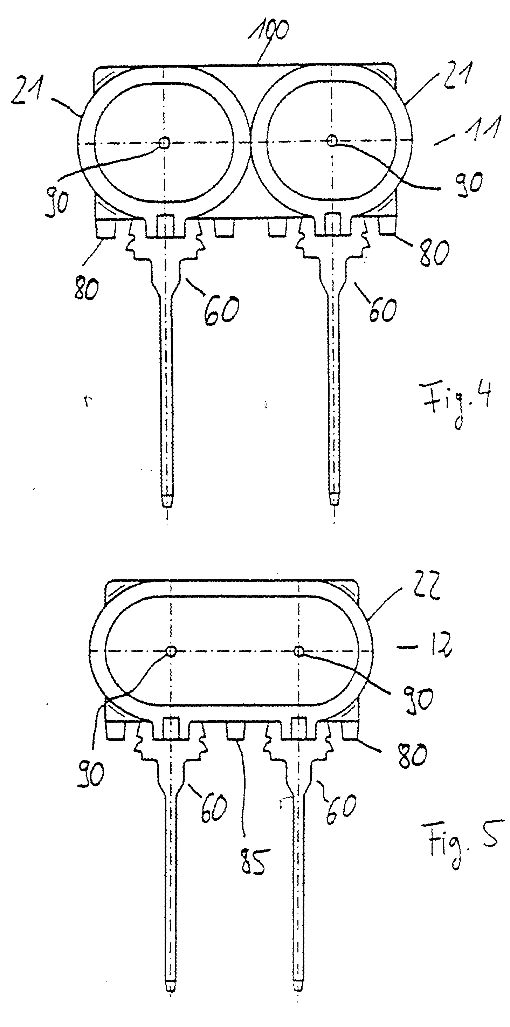

In Fig. 4 ist die Vorderansicht einer alternative Ausführungsform der in Fig. 1 gezeigten Fassung 10 dargestellt. Unter "Vorderansicht" versteht man in der gesamten Beschreibung den Blick auf die Fassungseite, auf die man beim Einsetzen der Fotodiode 31 in der Fassung 11 sehen würde. Die Fassung 11 umfaßt zwei getrennte Kappen 21, die zur Aufnahme von zwei Fotodioden dienen können. Jeder Kappe 21 ist ein Durchgang zur Aufnahme eines Kontaktstiftes 60 zugeordnet. Die Fassung 11 entspricht im übrigen im wesentlichen dem in Fig. 1 dargestellten Fassung 10. Jede Kappe 21 weist eine ovale Querschnittsfläche auf, deren Hauptachse rechtwinklig zur Längsachse der Kontaktstifte 60 liegt. Die ovale Querschnittsfläche ermöglicht nicht nur eine axiale sondern auch eine seitliche Positionierung der Fotodiode in der Kappe 21. Natürlich kann die Kappe 21 jede beliebige, d. h. auch rechteckige oder kreisförmige, Querschnittsfläche annehmen. Die Fassung 11 kann als Teil eines Steckverbinders verwendet werden, um beispielsweise zwei Fotodioden mit unterschiedlicher Empfindlichkeit in ein Lichtleitersystem einzubauen, wobei die Fotodioden je nach Bedarf gezielt angesteuert werden können.

In Fig. 5 ist die Vorderansicht eines alternativen Fassungs 12 dargestellt, der eine einzige Kappe 22 aufweist. Im Unterschied zu der in Fig. 1 gezeigten Kappe 20 sind der Kappe 22 zwei Durchgänge (nicht dargestellt) zur Aufnahme jeweils eines Kontaktstiftes 60 zugeordnet und weist die Kappe 20 zwei trichterförmige Einsenkungen zu den Durchgängen 90 auf. Die Durchgänge sind bezüglich der Einsetzrichtung einer Fotodiode nebeneinander angeordnet. Die Fassung 12 kann beispielsweise auch drei Durchgänge zur Aufnahme jeweils eines Kontaktstiftes aufweisen. Eine solche Fassung wäre beispielweise zur Aufnahme eines Fototransistors mit drei Anschlüssen geeignet.

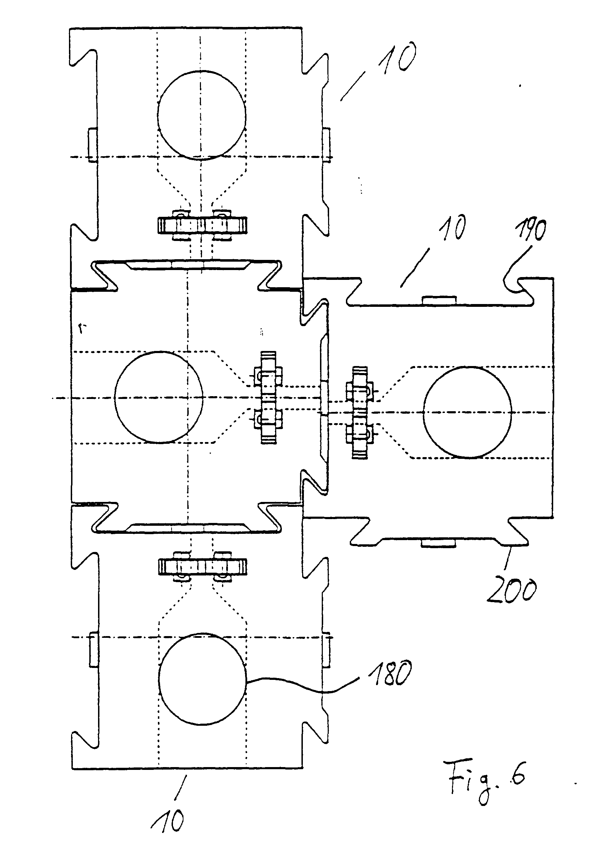

In Fig. 6 ist eine im wesentlichen sternförmige Anordnung von vier Fassungen dargestellt, die beispielsweise dem in Fig. 1 dargestellten Fassung 10 entsprechen. Damit die Fassungen gruppiert werden können, weist jede Fassung Aufnahmeeinrichtungen 190 und dazu komplementäre Halteeinrichtungen 200 auf. Diese Verbindungs- oder Kupplungseinrichtungen haben vorteilhafterweise die Form eines Schwalbenschwanzes. Die schwalbenschwanzförmigen Verbindungseinrichtungen 190, 200 sind so dimensioniert, daß die zusammengesetzten Fassungen ausreichend gegeneinander verschoben werden können, um herstellungsbedingte Ungenauigkeiten der Fassungkörper ausgleichen zu können. Jede Fassung weist eine Einlaßöffnung 180 auf. Wie noch erläutert wird, dienen die Einlaßöffnungen 180 dazu, beispielsweise eine dauerelastische Klebevergußmasse in die Kappen einzufüllen, um die genaue Lage der elektrischen und/oder elektronischen Bauteile in Bezug auf die Kappen zu fixieren.

In Fig. 7 ist die Vorderansicht einer weiteren alternativen Fassungen 13 dargestellt, der bis auf die Größe der Querschnittsfläche der Kappe 20 der in Fig. 1 dargestellten Fassung 10 entspricht. Die Innenfläche der Kappe 23 weist nach innen ragende Vorsprünge oder Stege 210 auf, die den Aufnahmebereich der Kappe 23 verkleinern. Die Stege 210 sind einstückig mit der Kappe 23 ausgebildet oder in Form eines getrennten Einsatzes in die Kappe 23 einsetzbar und mit dieser verrastbar.

Jede Fassung kann je nach Anwendungsfall auch mehrere, in Bezug auf die Einsetzrichtung der Fotodiode 30 hintereinander angeordnete Durchgänge 50 aufweisen, in die jeweils ein Kontaktstift 60 einsetzbar ist. Entsprechend der gewählten Anzahl von Kontaktstiften ist es möglich, die montierte Fotodiode getrennt anzusteuern. Zweckmäßigerweise kann jede Fassung einstückig aus einem isolationsfähigen Spritzgußmaterial hergestellt werden.

Nachfolgend wird der Montagevorgang der Fotodiode 30 mit der Fassung 10 näher erläutert. Zunächst wird auf die beiden je einen Anschlußdraht 70 tragenden Enden der Fotodiode 30 jeweils eine Fassung 10 aufgeschoben. Der Anschlußdraht 70 wird durch die trichterförmig verlaufende Innenfläche der Kappe 20 in die Löcher 90 und 110 eingefädelt und von diesen ausgerichtet und gehalten. Es sei ferner angenommen, daß die Fotodiode 30 an einer vorbestimmten Stelle auf einer nicht dargestellten Leiterplatte angeschlossen werden soll. Zu diesem Zweck müssen die beiden aufgebrachten Fassungen 10 einen präzisen Abstand zueinander aufweisen, der den Anschlußflächen auf der Leiterplatte entspricht. Da die Kappe 20 der Fassung 10 derart dimensioniert ist, daß nicht nur eine axiale, sondern vorteilhafterweise eine dreidimensionale Positionierung möglich ist, wird nunmehr die definierte Lage der Fotodiode 30 in Bezug auf die beiden Fassungen 10 festgelegt. Anschließend wird jeweils ein Kontaktstift 60 in den Durchgang 50 jeder Fassung 10 eingeschoben, bis eine Preßverbindung mit dem Anschlußdraht 70 hergestellt ist. Damit die genaue Lageposition der Fotodiode 30 bezüglich der aufgebrachten Fassungen nicht verloren geht, wird über die Einlaßöffnung 180 vorteilhafterweise eine dauerelastische Klebevergußmasse in jede Kappe 20 eingebracht. Als Füllmaterial kann ebenfalls ein UV-härtbarer Kunstharz verwendet werden. Der dauerelastische Klebstoff sorgt dafür, daß Vibrationen und externe Erschütterungen, die beispielsweise in einem Kraftfahrzeug auftreten, gedämpft auf die elektrische oder elektronische Komponente übertragen werden. Auf diese Weise kann die Zuverlässigkeit hinsichtlich der kontaktbildenden Preßverbindung sowie die Lebensdauer der Fotodiode deutlich verlängert werden.

## Patentansprüche

1. Fassung für elektrische und elektronische Komponenten mit Ausnahme von Leuchtmitteln,
mit folgenden Merkmalen:
die Fassung (10, 11, 12, 13) **ist einstückig ausgebildet und** weist eine oder mehrere Kappen (20-23) mit einem einseitig geöffneten aufnahmebereich zur Aufnahme wenigstens eines vorbestimmten, wenigstens einen Anschlußkontakt (70) aufweisenden Teils einer elektrischen oder elektronischen Komponente (30), und ein Kontaktelement (60) auf,
wobei die Kappe (20-23) derart bemessen ist, daß Fertigungsungenauigkeiten der Komponente (30) kompensierbar sind;
jeder Kappe (20-23) ist wenigstens eine Kammer (50) zur Aufnahme des Kontaktelementes (60) zugeordnet, wobei das Kontaktelement (60) derart ausgebildet ist, daß es im eingesetzten Zustand mit dem Anschlußkontakt (70) **innerhalb der Kammer (50)** eine elektrisch leitende Preßverbindung bildet.

2. Fassung nach Anspruch 1, dadurch gekennzeichnet, daß die Querschnittsfläche des Aufnahmeraums der Kappe (20-23) sich in Einsetzrichtung der Komponente (30) verjüngt und daß ein erstes Loch (90) von der Kappe (20-23) in die Kammer (50) zum Einfädeln des Anschlußkontaktes (70) führt.

3. Fassung nach Anspruch 1 oder 2, dadurch gekennzeichnet, daß die Kammer (50) in Bezug auf die Einsetzrichtung der Komponente (30) rechtwinklig verläuft und hinter der Kappe (20-23) angeordnet ist.

4. Fassung nach einem der Ansprüche 2 oder 3, dadurch gekennzeichnet, daß die die Kammer (50) begrenzende Rückseite (100) der Fassung (10-13) ein zum ersten.Loch (90) fluchtendes zweites Loch (110) aufweist, wobei der Abstand zwischen den Löchern (90, 110) derart bemessen ist, daß die während des Einsetzens des Kontaktelements (60) auftretenden Kräfte im wesentlichen nicht in die Komponente (30) geleitet werden.

5. Fassung nach einem der Ansprüche 1 bis 4, dadurch gekennzeichnet, daß die elektrische oder elektronische Komponente (30) mittels eines Füllmaterials, das durch eine Öffnung (180, 185) in die Kappe (20-23) einbringbar ist, fixierbar ist.

6. Fassung nach Anspruch 5, dadurch gekennzeichnet, daß das Füllmaterial eine dauerelastische Klebevergußmasse ist.

7. Fassung nach einem der Ansprüche 1 bis 6, gekennzeichnet durch Halte-, Rast- und/oder Führungseinrichtungen (190, 200) zum lösbaren Verbinden der Fassung (10, 11, 12, 13) mit wenigstens einer weiteren Fassung.

8. Fassung nach einem der Ansprüche 1 bis 7, dadurch gekennzeichnet, daß der Fassung (11) mehrere in definierter Lage zueinander angeordnete Kappen (21) aufweist und daß jeder Kappe (21) eine Kammer zum Einsetzen eines Kontaktelements (60) zugeordnet ist.

9. Fassung nach einem der Ansprüche 1 bis 8, dadurch gekennzeichnet, daß die Fassung (10-13) aus einem Dielektrikum hergestellt ist.

10. Fassung nach einem der Ansprüche 1 bis 9, gekennzeichnet durch Positioniereinrichtungen (80) und/oder eine Führungsnut (85) zum gezielten Anordnen der Fassung (10, 11, 12, 13) an einem Träger.

11. Fassung nach einem der Ansprüche 1 bis 10, dadurch gekennzeichnet, daß die Kappe (20-23) eine im wesentlichen ovale Querschnittsfläche hat.

12. Fassung nach einem der Ansprüche 1 bis 11, dadurch gekennzeichnet, daß das Kontaktelement (60) ein Kontaktstift mit zwei Kontaktschenkeln (130, 135) ist, die im eingesetzten Zustand mit dem Anschlußkontakt (70) eine Preßverbindung bilden.

13. Fassung nach Anspruch 12, dadurch gekennzeichnet, daß zwei Führungsnuten (120) in einem vorbestimmten Bereich der Kammer verlaufen und daß jeder Kontaktschenkel (130, 135) wenigstens einen Vorsprung (140, 145) aufweist, der beim Einsetzen des Kontaktelements (60) von der jeweiligen Führungsnut (120) aufgenommen wird.

14. Fassung nach einem der Ansprüche 1 bis 13, dadurch gekennzeichnet, daß das Kontaktelement (60) Rasteinrichtungen (150) aufweist, die im eingesetzen Zustand das Kontaktelement (60) in der Kammer (50) fixieren.

15. Fassung nach einem der Ansprüche 1 bis 14, dadurch gekennzeichnet, daß mehrere Kammern in bezug auf die Einsetzrichtung der Komponente hintereinander angeordnet sind.

16. Fassung nach einem der Ansprüche 1 bis 15, dadurch gekennzeichnet, daß an der Innenfläche der Kappe (23) mehrere parallel zur Einsetzrichtung der Komponente verlaufende Rippen (210) angeordnet sind.

17. Anordnung aus mehreren Fassungen nach einem der Ansprüche 1 bis 16, dadurch gekennzeichnet, daß die Fassungen lösbar oder fest miteinander verbunden sind.

18. Verfahren zum Fixieren und Kontaktieren wenigstens einer elektrischen oder elektronischen Komponente innerhalb einer Fassung (10, 11, 12, 13) nach einem der Ansprüche 1 bis 15, mit folgenden Schritten:
Einführen wenigstens eines vorbestimmten, wenigstens einen Anschlußkontakt aufweisenden Abschnitts der Komponente in die dem jeweiligen Abschnitt zugeordnete Kappe mit Freiraum zwischen der Kappe und dem Abschnitt,
Festlegen einer definierten Lage der Komponente in Bezug auf jede Fassung,
Einsetzen wenigstens eines Kontaktelementes in jede Kammer, die jeder Kappe zugeordnet ist, bis innerhalb der Kammer eine Preßverbindung mit dem Anschlußkontakt hergestellt ist,
Fixieren der Komponente in Bezug auf jede Fassung durch Einfüllen eines Füllmaterials.

## Claims

1. A socket for electric and electronic components excluding light fittings, having the following features:
the socket (10, 11, 12, 13) is in one piece and has one or more caps (20 - 23) with a receiving zone open on one side for receiving at least one predetermined part, containing at least one connecting contact (70) of an electric or electronic component (30), and also comprises a contact element (60), the cap (20 - 23) being so dimensioned as to compensate inaccuracies in the manufacture of the component (30);
each cap (20 - 23) is associated with at least one chamber (50) for receiving the contact element (60), the contact element (60) being so constructed that when inserted it makes an electrically conducting compression joint with the connecting contact (70) inside the chamber (50).

2. A socket according to claim 1, characterised in that the cross-sectional surface of the receiving chamber in the cap (20 - 23) tapers in the direction of insertion of the component (30), and in that a first hole (90) leads from the cap (20 - 23) into the chamber (50) for threading of the connecting contact (70).

3. A socket according to claim 1 or 2, characterised in that the chamber (50) extends at right angles to the direction of insertion of the component (30) and is disposed behind the cap (20-23).

4. A socket according to claim 2 or 3, characterised in that the back (100) of the socket (10 - 13) bounding the chamber (50) has a second hole (110) in line with the first hole (90), the distance between the holes (90, 110) being made such that the forces exerted during insertion of the contact element are not significantly transmitted to the component (30).

5. A socket according to any of claims 1 to 4, characterised in that the electric or electronic component (30) can be fixed by a filling material insertable through an opening (180, 185) into the cap (20 - 23).

6. A socket according to claim 5, characterised in that the filling material is a permanently elastic adhesive sealant.

7. A socket according to any of claims 1 to 6, characterised by retaining, catch and/or guide devices (190, 200) for releasably connecting the socket (10, 11, 12, 13) to at least one other socket.

8. A socket according to any of claims 1 to 7, characterised in that the socket (11) has a number of caps (21) disposed in defined positions relative to one another and in that each cap (21) is associated with a chamber for inserting a contact element (60).

9. A socket according to any of claims 1 to 8, characterised in that the socket (10 - 13) is made of a dielectric.

10. A socket according to any of claims 1 to 9, characterised by positioning devices (80) and/or a guide groove (85) for controlled mounting of the socket (10, 11, 12, 13) on a support.

11. A socket according to any of claims 1 to 10, characterised in that the cap (20 - 23) has a substantially oval cross-sectional surface.

12. A socket according to any of claims 1 to 11, characterised in that the contact element (60) is a contact pin having two arms (130, 135), which form a compression joint with the connecting contact (70) when inserted.

13. A socket according to claim 12, characterised in that two guide grooves (120) extend in a predetermined region of the chamber and in that each contact arm (130, 135) has at least one projection (140, 145) which is received by the respective guide groove (120) when the contact element (60) is inserted.

14. A socket according to any of claims 1 to 13, characterised in that the contact element (60) has catch means (150) which fix the contact element (60) in the chamber (50) when inserted.

15. A socket according to any of claims 1 to 14, characterised in that a number of chambers are disposed one behind the other relative to the direction of insertion of the component.

16. A socket according to any of claims 1 to 15, characterised in that a number of ribs (210) extending parallel to the direction of insertion of the component are disposed on the inner surface of the cap (23).

17. An arrangement of a number of sockets according to any of claims 1 to 16, characterised in that the sockets are releasably or firmly connected to one another.

18. A method of fixing and contacting at least one electric or electronic component inside a socket (10, 11, 12, 13) according to any of claims 1 to 15, comprising the following steps:
inserting at least one predetermined portion, comprising at least one connecting contact, of the component into the cap associated with the respective portion, leaving a free space between the cap and the portion,
establishing a defined position of the component relative to each socket,
inserting at least one contact element into each chamber associated with each cap, until a compression joint with the connecting contact is made inside the chamber, and
fixing the component relative to each socket by introducing a filling material.

## Revendications

1. Douille pour composants électriques et électroniques, à l'exception de moyens d'éclairage,
avec les caractéristiques suivantes :
la douille (10, 11, 12, 13) est conçue d'un seul tenant et comporte un ou plusieurs capuchons (20 à 23) avec une zone de logement ouverte d'un côté, destinée à loger au moins une partie prédéterminée, comportant au moins un contact de connexion (70), d'un composant électrique ou électronique (30), et un élément de contact (60), le capuchon (20 à 23) étant dimensionné de telle sorte que des imprécisions de fabrication du composant (30) peuvent être compensées ;
il est associé à chaque capuchon (20 à 23) au moins une chambre (50) pour loger l'élément de contact (60), l'élément de contact (60) étant conçu de telle sorte que, à l'état monté, il forme avec le contact de connexion (70) à l'intérieur de la chambre (50) une connexion serrée électriquement conductrice.

2. Douille selon la revendication 1, caractérisée en ce que la surface de section transversale de l'espace de logement du capuchon (20 à 23) se rétrécit dans la direction de montage du composant (30) et en ce qu'un premier trou (90) conduit du capuchon (20 à 23) dans la chambre (50) pour enfiler le contact de connexion (70).

3. Douille selon la revendication 1 ou 2, caractérisée en ce que la chambre (50) s'étend en angle droit par rapport à la direction de montage du composant (30) et est agencée derrière le capuchon (20 à 23).

4. Douille selon l'une des revendications 2 ou 3, caractérisée en ce que l'arrière (100), limitant la chambre (50), de la douille (10 à 13) comporte un deuxième trou (110) aligné avec le premier trou (90), la distance entre les trous (90, 110) étant dimensionnée de telle sorte que les forces apparaissant pendant le montage de l'élément de contact (60) ne sont globalement pas conduites dans le composant (30).

5. Douille selon l'une des revendications 1 à 4, caractérisée en ce que le composant électrique ou électronique (30) peut être fixé au moyen d'un matériau de remplissage qui peut être introduit dans le capuchon (20 à 23) par l'intermédiaire d'une ouverture (180, 185).

6. Douille selon la revendication 5, caractérisée en ce que le matériau de remplissage est une masse à sceller collante à élasticité permanente.

7. Douille selon l'une des revendications 1 à 6, caractérisée par des dispositifs de maintien, d'enclenchement et/ou de guidage (190, 200) pour l'assemblage amovible de la douille (10, 11, 12, 13) à au moins une autre douille.

8. Douille selon l'une des revendications 1 à 7, caractérisée en ce que la douille (11) comporte plusieurs capuchons (21) agencés dans des positions définies les unes par rapport aux autres et en ce qu'il est associé à chaque capuchon (21) une chambre pour le montage d'un élément de contact (60).

9. Douille selon l'une des revendications 1 à 8, caractérisée en ce que la douille (10 à 13) est fabriquée à partir d'un diélectrique.

10. Douille selon l'une des revendications 1 à 9, caractérisée par des dispositifs de positionnement (80) et/ou par une rainure de guidage (85) pour l'agencement contrôlé de la douille (10, 11, 12, 13) sur un support.

11. Douille selon l'une des revendications 1 à 10, caractérisée en ce que le capuchon (20 à 23) a une surface de section transversale globalement ovale.

12. Douille selon l'une des revendications 1 à 11, caractérisée en ce que l'élément de contact (60) est une broche de contact avec deux branches de contact (130, 135) qui forment à l'état monté une connexion serrée avec le contact de connexion (70).

13. Douille selon la revendication 12, caractérisée en ce que deux rainures de guidage (120) s'étendent dans une zone prédéterminée de la chambre et en ce que chaque branche de contact (130, 135) comporte au moins une partie en saillie (140, 145) qui vient se loger dans la rainure de guidage (120) respective lors du montage de l'élément de contact (60).

14. Douille selon l'une des revendications 1 à 13, caractérisée en ce que l'élément de contact (60) comporte des dispositifs d'enclenchement (150) qui, à l'état monté, fixent l'élément de contact (60) dans la chambre (50).

15. Douille selon l'une des revendications 1 à 14, caractérisée en ce que plusieurs chambres sont agencées les unes derrière les autres par rapport à la direction de montage du composant.

16. Douille selon l'une des revendications 1 à 15, caractérisée en ce que plusieurs nervures (210) s'étendant parallèlement à la direction de montage du composant sont agencées sur la surface intérieure du capuchon (23).

17. Dispositif composé de plusieurs douilles selon l'une des revendications 1 à 16, caractérisé en ce que les douilles sont assemblées amovibles ou inamovibles les unes aux autres.

18. Procédé pour la fixation et la mise en contact d'au moins un composant électrique ou électronique à l'intérieur d'une douille (10, 11, 12, 13) selon l'une des revendications 1 à 15,
avec les étapes suivantes :
introduction d'au moins un tronçon prédéterminé, comportant au moins un contact de connexion, du composant dans le capuchon associé au tronçon respectif avec de l'espace libre entre le capuchon et le tronçon,
détermination d'une position définie du composant par rapport à chaque douille,
montage d'au moins un élément de contact dans chaque chambre, qui est associée à chaque capuchon, jusqu'à ce qu'une connexion serrée avec le contact de connexion soit réalisée à l'intérieur de la chambre,
fixation du composant par rapport à chaque douille par remplissage d'un matériau de remplissage.
